# EUROPÄISCHE PATENTSCHRIFT

(11) **EP 4 150 357 B1**
(45) Veröffentlichungstag und Bekanntmachung des Hinweises auf die Patenterteilung: **18.06.2025**
(21) Anmeldenummer: 21726604.8
(22) Anmeldetag: 11.05.2021
(51) Int. Cl.: G01R 31/327, G01R 31/62, G01R 1/04, H05K 5/00

(54) **PRÜFSYSTEM SOWIE HAUPTGERÄT UND ZUSATZGERÄT DAVON ZUR PRÜFUNG EINER ELEKTRISCHEN EINRICHTUNG**
TEST SYSTEM AND MAIN DEVICE AND ADDITIONAL DEVICE THEREOF FOR TESTING AN ELECTRIC DEVICE
SYSTÈME DE TEST ET DISPOSITIF PRINCIPAL ET SON DISPOSITIF SUPPLÉMENTAIRE POUR TESTER UN DISPOSITIF ÉLECTRIQUE

(30) Priorität: 13.05.2020 AT 504162020
(43) Veröffentlichungstag der Anmeldung: 22.03.2023
(73) Patentinhaber: Omicron electronics GmbH, 6833 Klaus (AT)
(72) Erfinder: STUDER, Klaus, 6723 Blons (AT); KAUFMANN, Reinhard, 6721 Thüringerberg (AT); RÄDLER, Michael, 6833 Klaus (AT); UNTERER, Boris, 6800 Feldkirch (AT); DE VILLIERS, Wernich, 6850 Dornbirn (AT); KUKUK, Matthias, 6923 Lauterach (AT); FEUSTEL, Felix, 6850 Dornbirn (AT); BITSCHNAU, Lukas, 6751 Braz (AT); SCHEDLER, Horst, 6830 Rankweil (AT)
(74) Vertreter: Kraus & Lederer PartGmbB
(86) Internationale Anmeldenummer: PCT/EP2021/062460
(87) Internationale Veröffentlichungsnummer: WO 2021/228841

(56) Entgegenhaltungen:
- US-A- 5 131 272
- US-A1- 2004 047 116
- US-A1- 2012 178 303
- US-A1- 2016 080 666

## Beschreibung

### GEBIET DER ERFINDUNG

Die Erfindung betrifft ein Prüfsystem zur Prüfung einer mit einer elektrischen Spannung oder einem elektrischen Strom betriebenen elektrischen Einrichtung.

Insbesondere liegt die Erfindung auf dem Gebiet der Hochspannungs- und Hochstrommesstechnik und betrifft insbesondere ein Prüfsystem zur Prüfung einer Hochspannungseinrichtung, ein portables Hauptgerät und ein portables Zusatzgerät zur Prüfung einer Hochspannungseinrichtung sowie ein Hybridkabel zur Verbindung eines portablen Hauptgeräts mit einem portablen Zusatzgerät.

### HINTERGRUND

In elektrischen Energieversorgungsnetzen werden üblicherweise Hochspannungseinrichtungen oder allgemeiner Elektroenergieeinrichtungen wie Leistungstransformatoren oder Schaltanlagen zum Wandeln und Verteilen von elektrischer Energie eingesetzt. Auch werden hierbei gewöhnlich weitere Elektroenergieeinrichtungen wie Hochspannungswandler oder Hochstromwandler, Leistungsschalter, Leistungsgeneratoren oder Relais zum Erzeugen und Verteilen von elektrischer Energie oder auch als Bestandteile eine Schutzsystems eingesetzt. Auch im industriellen Umfeld finden solche Elektroenergieeinrichtungen oder weiter Elektroenergieeinrichtungen wie elektrische Leistungsmotoren Anwendung.

Zur Inbetriebnahme oder zur Wartung von Anlagen mit solchen Hochspannungseinrichtungen ist es erforderlich, deren Funktionen und Eigenschaften zu überprüfen, wobei an den jeweiligen Prüfling ein geeignetes Prüfsignal angelegt und die sich dabei einstellende Prüfantwort des Prüflings zur Messen einer entsprechenden Messgröße erfasst und ausgewertet wird. Beispiele hierfür sind Messungen von elektrischen Kontaktwiderständen, des Schaltverhaltens, des Leitverhaltens, des Übersetzungsverhältnisses oder des Verlustfaktors eines derartigen Prüflings sowie Isolationsmessungen oder Teilentladungsmessungen etc.

Derartige Prüfungen werden häufig im Feldeinsatz - also etwa im Außenbereich oder in einer industriellen Umgebung - durchgeführt. Dabei sollen die verwendeten Gerätschaften besonders für den Feldeinsatz ein geringes Gewicht haben, flexibel einsetzbar und für den Transport zum jeweiligen Einsatzort robust sein.

Die US 2004 / 047 116 A1 offenbart ein Prüfsystem mit einem ersten portablen Gerät, welches ein erstes Gehäuse aufweist, und einem zweiten portablen Gerät, welches ein zweites Gehäuse aufweist. Das erste Gerät ist mit dem zweiten Gerät durch jeweilige Verbindungsanordnungen mechanisch lösbar verbindbar. Zudem sind die Geräte elektrisch verbindbar.

Die US 2012 / 178303 A1 offenbart ein Hybridkabel mit mehreren Leitungen.

### ZUSAMMENFASSUNG DER ERFINDUNG

Es besteht daher ein Bedarf an einem Prüfsystem zur Prüfung einer elektrischen Einrichtung, insbesondere einer Hochspannungseinrichtung, welches einfach transportierbar ist und über eine hohe Leistungsfähigkeit sowie einen hohen Funktionsumfang verfügt und darüber hinaus eine hohe Betriebssicherheit ermöglicht.

Die Erfindung erfüllt diesen Bedarf durch ein Prüfsystem zur Prüfung einer elektrischen Einrichtung gemäß Anspruch 1. Vorteilhafte Ausführungsformen, Weiterbildungen und Varianten der vorliegenden Erfindung sind Gegenstand der abhängigen Ansprüche.

Die Erfindung kann dabei bevorzugt zum Prüfen einer Hochspannungseinrichtung eingesetzt werden, ohne jedoch darauf beschränkt zu sein. Ebenso können mit der Erfindung auch Betriebsmittel im Niederspannungsbereich oder Mittelspannungsbereich, d.h. allgemein in sämtlichen Spannungsebenen, geprüft werden.

Das zur Prüfung einer elektrischen Einrichtung ausgestaltete Prüfsystem umfasst ein portables Hauptgerät mit einem Gehäuse und einer an dem Gehäuse angeordneten mechanischen Verbindungsanordnung oder eines entsprechenden Verbindungsmechanismus sowie einer an dem Gehäuse angeordneten elektrischen Anschlussanordnung oder elektrischen Steckerschnittstelle. Darüber hinaus umfasst das Prüfsystem ein von dem portablen Hauptgerät separates portables Zusatzgerät mit einem Gehäuse und einer an diesem Gehäuse angeordneten mechanischen Verbindunganordnung sowie einer an diesem Gehäuse angeordneten elektrischen Anschlussanordnung. Das portable Hauptgerät kann mit dem portablen Zusatzgerät durch Kopplung der mechanischen Verbindungsanordnungen lösbar mechanisch zu einer baulichen Einheit verbunden werden, wobei eine elektrische Verbindung zwischen dem portable Hauptgerät und dem portablen Zusatzgerät über die elektrischen Anschlussanordnungen hergestellt werden kann.

Das portable Hauptgerät weist eine Leistungsverstärkereinrichtung zum Erzeugen eines Leistungssignals, welches an das portable Zusatzgerät über die erste elektrische Anschlussanordnung und die zweite elektrische Anschlussanordnung zu übertragen ist, auf.

Das portable Zusatzgerät weist eine Prüfsignalvorrichtung zur Erzeugung eines an die elektrische Einrichtung auszugebenden Prüfsignals auf Grundlage des Leistungssignals des portablen Hauptgeräts auf.

Das portable Hauptgerät weist zudem eine Messeinrichtung zum Messen einer Messgröße der elektrischen Einrichtung als Prüfantwort auf das Prüfsignal des portablen Zusatzgeräts auf.

Die Erfindung ist vorzugsweise zur Prüfung einer elektrischen Hochspannungseinrichtung ausgestaltet. Im Sinne der Erfindung ist dabei unter einer "Hochspannungseinrichtung" jede Einrichtung zu verstehen, welche mit einer hohen elektrischen Spannung, d.h. einer Spannung im Bereich von mindestens 1 kV, oder einem entsprechend hohen elektrischen Strom betrieben wird.

Des Weiteren ist im Sinne der Erfindung unter "portabel" zumindest zu verstehen, dass das System bzw. das entsprechende Gerät von einem Benutzer transportiert und insbesondere getragen werden kann.

Ein Vorteil des portablen Hauptgeräts und des portablen Zusatzgerät mit jeweils separaten Gehäusen liegt insbesondere darin, dass diese jeweils einzeln zum jeweiligen Einsatzort - besonders beim Feldeinsatz - transportiert werden können. Auch wird es ermöglicht, die Funktionalität des Prüfsystems über verschiedene Zusatzgeräte - abhängig von den durchzuführenden Messungen/Prüfungen - zu erweitern.

Sowohl das Hauptgerät als auch das Zusatzgerät können gemäß einem bevorzugten Ausführungsbeispiel jeweils als ein eigenständiges Prüfgerät, insbesondere als ein Hochspannungsprüfgerät, ausgestaltet sein, wobei durch Kopplung des Hauptgeräts mit dem Zusatzgerät ein Prüfsystem mit variabler Funktion und/oder einem erweitertem Funktionsumfang erhalten wird, welches nach außen hin als eine bauliche Einheit mit einem entsprechend ausgestalteten Kombinationsmessgerät in Erscheinung tritt. Wird die Kopplung zwischen dem Hauptgerät und dem Zusatzgerät gelöst, können das Hauptgerät und das Zusatzgerät wieder jeweils als separate Messgeräte betrieben werden.

Bei Kopplung des Hauptgeräts mit dem Zusatzgerät kann das Hauptgerät insbesondere die Steuerung der Erzeugung eines Prüfsignals für die zu prüfende elektrische Einrichtung oder die automatische Steuerung des Ablaufs der gesamten Prüfung übernehmen und hierzu über eine entsprechend ausgestaltete Steuerungseinrichtung verfügen.

Das Prüfsignal kann insbesondere ein Hochspannungsprüfsignal mit einer Spannung von mindestens 1kV sein.

Die Prüfantwort der zu prüfenden elektrische Einrichtung auf das Prüfsignal wird wie oben definiert von einer Messeinrichtung des Hauptgeräts zum Messen einer gewünschten Messgröße der elektrische Einrichtung ausgewertet, wobei hierzu die Prüfantwort von dem Zusatzgerät erfasst und an das Hauptgerät übertragen werden kann. In diesem Fall ist somit das Zusatzgerät mit sämtlichen Messeingängen und Messausgängen ausgestattet, um die Messung selbst durchführen zu können. Diese Vorgehensweise kann insbesondere bei der Prüfung von Spannungswandlern, insbesondere Hochspannungswandlern, empfehlenswert sein. Ebenso ist es jedoch auch möglich, dass die Prüfantwort direkt von dem Hauptgerät erfasst und ausgewertet wird. Die letztgenannte Vorgehensweise kann für die Prüfung von Stromwandlern, insbesondere Hochstromwandlern, empfehlenswert sein.

Bei Kopplung des Hauptgeräts mit dem Zusatzgerät kann eine kompakte und handliche bauliche Einheit insbesondere dann erzielt werden, wenn das Hauptgerät und das Zusatzgerät an ihren Kontaktflächen, an welchen sie durch die mechanischen Verbindungsanordnungen miteinander mechanisch gekoppelt bzw. verbunden werden können, identische oder im Wesentlichen ähnliche Abmessungen aufweisen. Vorzugsweise verfügen das Hauptgerät und das Zusatzgerät über denselben Formfaktor, d.h. über dieselben oder im Wesentlichen ähnlichen Außenabmessungen.

Bei geeigneter Wahl der Anordnung der elektrischen Anschlüsse lassen sich das portable Hauptgerät und das portable Zusatzgerät bereits mit (genau) einem Kabel für die Prüfung der elektrischen Einrichtung elektrisch verbinden. Hiermit kann die Handhabung - besonders im Feldeinsatz - vereinfacht und/oder verlässlicher gemacht werden. Das Kabel kann in Form eines Hybridkabels ausgestaltet sein, wobei über das Kabel sowohl Leistungssignale als auch Datensignale und/oder Sicherheitssignale zwischen dem portablen Hauptgerät und dem portablen Zusatzgerät übertragen werden können. Insbesondere ist das Hybridkabel derart ausgestaltet, dass die verschiedenen Signale bzw. Informationen gleichzeitig übertragen werden können- Für jede Signalart können hierzu separate Leitungen in dem Hybridkabel vorgesehen sein, wobei jedoch auch möglich ist, dass verschiedene Signale oder Informationen über eine gemeinsame Leitung übertragen werden.

In einer Ausführungsform kann das portable Hauptgerät ohne Leistungstransformator oder Hochspannungstransformator/Hochstromtransformator ausgestaltet sein, sondern der Leistungstransformator ist - sofern ein derartiger Leistungstransformator für das Prüfsystem zum Durchführen von bestimmten Prüfungen erforderlich ist - nur in dem jeweiligen portablen Zusatzgerät vorgesehen. Auf diese vorteilhafte Weise lässt sich das Gewicht des portablen Hauptgeräts reduzieren und/oder lässt sich das Prüfsystem - gegebenenfalls modular unterteilt in mehrere Teile wie Hauptgerät und Zusatzgerät - leichter transportieren.

Allgemein ist es durch die Verwendung des Hauptgeräts und des separaten Zusatzgeräts möglich, die Funktionen des gewünschten Prüfsystems beliebig auf das Hauptgerät und das Zusatzgerät aufzuteilen, so dass insgesamt die Variabilität und Flexibilität aber auch die Betriebssicherheit erhöht werden kann. Bei Benutzung des Hauptgeräts mit einem Satz von mehreren unterschiedlichen Zusatzgeräten, welche jeweils über unterschiedliche Funktionen und/oder Komponenten verfügen, kann durch Wahl des jeweils geeigneten Zusatzgeräts ein modular aufgebautes Prüfsystem erhalten werden, dessen Funktionalität bestmöglich an die jeweiligen Gegebenheiten vor Ort und an die jeweils gewünschten Prüfbedingungen angepasst ist.

Weitere Vorteile, Merkmale und Anwendungsmöglichkeiten ergeben sich aus der nachfolgenden detaillierten Beschreibung von Ausführungsbeispielen und/oder aus den Figuren.

### KURZE BESCHREIBUNG DER FIGUREN

Die Erfindung wird nachfolgend unter Bezugnahme auf die Figuren anhand vorteilhafter Ausführungsbeispiele näher erläutert. Gleiche Elemente oder Bauteile der Ausführungsbeispiele sind jeweils mit gleichen Bezugszeichen versehen, falls dies nicht anders beschrieben ist oder sich nicht anderes aus dem Kontext ergibt.
Fig. 1 zeigt ein Prüfsystem nach einer Ausführungsform;
Fig. 2 zeigt ein portables Hauptgerät nach einer Ausführungsform; und
Fig. 3 zeigt ein Hybridkabel nach einer Ausführungsform.

Die Figuren sind schematische Darstellungen verschiedener Ausführungsformen und/oder Ausführungsbeispiele der vorliegenden Erfindung. In den Figuren dargestellte Elemente und/oder Bauteile sind nicht notwendigerweise maßstabsgetreu dargestellt. Vielmehr sind die verschiedenen in den Figuren dargestellten Elemente und/oder Bauteile derart wiedergegeben, dass ihre Funktion und/oder ihr Zweck dem Fachmann verständlich werden.

In den Figuren dargestellte Verbindungen und Kopplungen zwischen funktionellen Einheiten und Elementen können auch als indirekte Verbindungen oder Kopplungen implementiert werden. Insbesondere können Datenverbindungen drahtgebunden oder drahtlos, also insbesondere als Funkverbindung, ausgebildet sein. Auch können bestimmte Verbindungen, etwa elektrische Verbindungen, etwa zur Energieversorgung, der Übersichtlichkeit halber nicht dargestellt sein.

### DETAILLIERTE BESCHREIBUNG VON AUSFÜHRUNGSBEISPIELEN

Die Erfindung wird nachfolgend anhand einer Prüfung einer Hochspannungseinrichtung beschrieben, ohne jedoch darauf beschränkt zu sein. Ebenso können mit der Erfindung auch Betriebsmittel im Niederspannungsbereich oder Mittelspannungsbereich, d.h. allgemein in sämtlichen Spannungsebenen, geprüft werden.

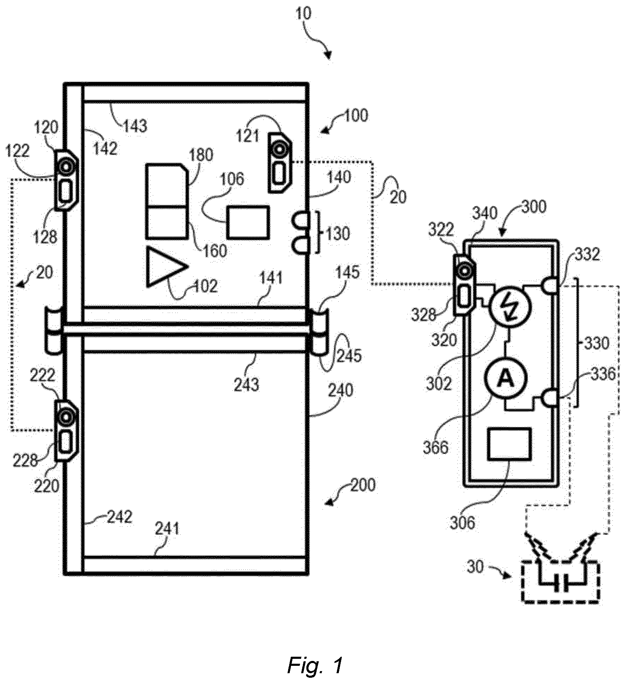

In Fig. 1 ist schematisch ein Prüfsystem 10 nach einer Ausführungsform der vorliegenden Erfindung zur Prüfung einer Hochspannungseinrichtung, d.h. einer mit einer hohen elektrischen Spannung bzw. mit einem entsprechenden hohen elektrischen Strom betriebenen elektrischen Einrichtung, schematisch dargestellt.

In einem Ausführungsbeispiel weist das Prüfsystem 10 ein portables Hauptgerät 100 sowie ein portables Zusatzgerät 300 und ein weiteres portables Zusatzgerät 200 auf, welche miteinander je über ein Hybridkabel - in einigen Varianten je ein Hybridkabel 20 des Prüfsystems 10 - verbunden sind.

In Fig. 1 ist darüber hinaus auch die zu prüfende Hochspannungseinrichtung 30 dargestellt.

Das portable Hauptgerät 100 weist ein Gehäuse 140 mit einer Bodenfläche 141, einer Seitenfläche 142 und einer Oberseite 143 auf. Dabei ist die Bodenfläche 141 dafür vorgesehen, beim Stellen des portablen Hauptgeräts 100 auf einen Untergrund diesem zugewandt zu sein. Entsprechend weist das portable Zusatzgerät 200 ein Gehäuse 240 mit einer Bodenfläche 241, einer Seitenfläche 242 und einer Oberseite 243 auf. Auch das portable Zusatzgerät 300 weist ein Gehäuse 340 auf, wobei dieses in einigen Varianten dem Gehäuse 240 des portablen Zusatzgeräts 200 mit entsprechenden elektrischen Anschlüssen und mechanischen Verbindungselemente entsprechen kann und weitere Details der Übersichtlichkeit halber nicht dargestellt sind.

Außerdem weisen die Gehäuse 140, 240 des portablen Hauptgeräts 100 und des portablen Zusatzgeräts 200 jeweils mechanische Verbindungselemente 145, 245 auf, die eingerichtet sind, das portable Hauptgerät 100, wenn es mit seiner Bodenfläche 141 auf die Oberseite 243 des Zusatzgeräts 200 gestellt ist, mit diesem Zusatzgerät 200 lösbar, insbesondere kraftschlüssig, formschlüssig oder reibschlüssig, zu verbinden. Auf diese vorteilhafte Weise lassen sich das Hauptgerät 100 und das Zusatzgerät 200 - etwa im Feldeinsatz - miteinander mechanisch verbinden, wodurch insbesondere eine Bedienung des portablen Hauptgeräts erleichtert und/oder die Handhabung des Prüfsystems 10 verbessert werden kann.

Bei dem in Fig. 1 dargestellten Ausführungsbeispiel ist das Hauptgerät 100 auf das Zusatzgerät 200 gestellt, so dass sich die Bodenfläche 141 des Hauptgeräts 100 auf der Oberseite 243 des Zusatzgeräts befindet. Die Abmessungen der Bodenfläche 141 und des Oberseite 243 sind vorzugsweise derart, dass sie einander weitgehend entsprechen, so dass insgesamt bei Kopplung des Hauptgeräts 100 mit dem Zusatzgerät eine kompakte einheitliche Bauform erhalten werden kann. Wie in Fig. 1 angedeutet ist, können allgemein die einzelnen Geräte 100, 200, 300 weitgehend über denselben Formfaktor, d.h. dieselben Außenabmessungen verfügen.

Jedes der Geräte 100, 200, 300 ist vorzugsweise als ein eigenständiges Messgerät ausgestaltet.

Das portable Hauptgerät 100 weist diesbezüglich eine Anschlussanordnung 120, eine weitere Anschlussanordnung 121 und einen oder mehrere Prüfanschlüsse 130 zum Anschließen der Hochspannungseinrichtung 30 auf, welche am Gehäuse 140 angeordnet sind. Die Anschlussanordnung 120 (und entsprechend die weitere Anschlussanordnung 121) weist vorzugsweise nur Anschlüsse 122, 128 auf, die alle weniger als einen vorbestimmten Abstand derart voneinander entfernt sind, dass alle diese mit genau einem Ende des Hybridkabels 20 verbunden werden können. Hierdurch lässt sich ein Anschließen des Hybridkabels erleichtern und lassen sich etwa gegenüber anderen Systemen mit mehreren Kabeln oder größeren Abständen ein etwaiges Gewirr aus Kabeln vermeiden und so die Sicherheit verbessern. Eine erste Gruppe 122 der Anschlüsse der Anschlussanordnung 120 ist zur Ausgabe eines Leistungssignals eingerichtet und eine zweite Gruppe 128 der Anschlüsse der Anschlussanordnung 120 ist zur Datenkommunikation eingerichtet.

Zudem kann eine (nicht gezeigte) weitere Gruppe von Anschlüssen zur Übertragung von Sicherheitssignalen vorgesehen sein, um somit Sicherheitsfunktionen des Prüfsystems zu steuern.

Das weitere portable Zusatzgerät 200 weist eine korrespondierende Anschlussanordnung 220 auf, welche an der Seitenfläche 242 angeordnet ist. Auch die Anschlussanordnung 220 weist vorzugsweise Anschlüsse 222, 228 auf, die alle weniger als den vorbestimmten Abstand voneinander entfernt sind. Dabei ist eine erste Gruppe 222 der Anschlüsse der Anschlussanordnung 220 zum Empfangen des Leistungssignals eingerichtet und eine zweite Gruppe 228 der Anschlüsse der Anschlussanordnung 220 des weiteren portablen Zusatzgeräts 200 zur Datenkommunikation und oder zur Übertragung der Sicherheitssignale eingerichtet. Eines der Hybridkabel 20 ist mit einem Ende an die Anschlussanordnung 120 des portablen Hauptgeräts 100 und mit einem anderen Ende an die Anschlussanordnung 220 des weiteren portablen Zusatzgeräts 200 angeschlossen und verbindet somit das Hauptgerät 100 und das weitere Zusatzgerät 200.

Entsprechend weist das portable Zusatzgerät 300 einen oder mehrere Prüfanschlüsse 330 sowie eine Anschlussanordnung 320 auf, welche am Gehäuse 340 des portablen Zusatzgeräts 300 angeordnet sind. Dabei ist eine erste Gruppe 322 an Anschlüssen der Anschlussanordnung 320 zum Empfangen des Leistungssignals eingerichtet und eine zweite Gruppe 328 an Anschlüssen der Anschlussanordnung 320 zur Datenkommunikation und/oder zur Übertragung der Sicherheitssignale eingerichtet, wobei alle diese Anschlüsse vorzugsweise weniger als den vorbestimmten Abstand voneinander entfernt sind.

Das portable Zusatzgerät 300 (und entsprechend bei einigen Varianten das weitere portable Zusatzgerät 200) ist in einem Prüfmodus betreibbar und in diesem eingerichtet, das empfangene Leistungssignal in ein erstes Prüfsignal umzuwandeln und über einen Ausgangsanschluss 332 der Prüfanschlüsse 330 des portablen Zusatzgeräts 300 an die dort anzuschließende Hochspannungseinrichtung 30 anzulegen.

Außerdem weist das portable Hauptgerät 100 eine Leistungsverstärkereinrichtung 102 zum Erzeugen des Leistungssignals, eine Messeinrichtung 160 für ein Messen von Messgrößen und eine Steuerungseinrichtung 180 zum Steuern der Leistungsverstärkereinrichtung 102 und der Messeinrichtung 160 - sowie in einigen Varianten einen zum Bereitstellen eines Zeitsignals eingerichteten Zeitgeber 106 - auf, welche jeweils innerhalb des Gehäuses 140 des Hauptgeräts 100 angeordnet sind.

Das portable Zusatzgerät 300 ist in einigen Varianten, wie auch in Fig. 1 dargestellt, als eine Hochspannungsprüfsignalvorrichtung ausgebildet und weist einen Hochspannungstransformator 302, eine Stromsensoreinrichtung 366 und einen zum Bereitstellen eines Zeitsignals eingerichteten Zeitgeber 306 auf, welche jeweils im Gehäuse 340 des portablen Zusatzgeräts 300 angeordnet sind. Zudem ist die Steuerungseinrichtung 180 des portablen Hauptgeräts 100 eingerichtet, für eine erste Prüfung der Hochspannungseinrichtung 30 das portable Zusatzgerät 300 über die Anschlussanordnung 121 und die Anschlussanordnung 320 durch eines der Hybridkabel 20 derart anzusteuern, dass das portable Zusatzgerät 300 veranlasst wird, den Prüfmodus des portablen Zusatzgeräts 300 zu aktivieren. Des Weiteren ist die Steuerungseinrichtung 180 für die erste Prüfung eingerichtet, mittels der Leistungsverstärkereinrichtung 102 das Leistungssignal zu erzeugen und über die Anschlussanordnungen 121, 320 an das portable Zusatzgerät 300 auszugeben.

Die Hochspannungsprüfsignalvorrichtung - also das portable Zusatzgerät 300 - ist im Prüfmodus eingerichtet, das Leistungssignal mittels des Hochspannungstransformators 302 in das erste Prüfsignal derart umzuwandeln, dass das Leistungssignal und das erste Prüfsignal galvanisch getrennt sind und das erste Prüfsignal eine für eine Hochspannungsprüfung geeigneten Spannung von mindestens 1kV besitzt.

Weiter ist das portable Zusatzgerät 300 im Prüfmodus eingerichtet, ein erstes analoges Messsignal, welches infolge des ersten Prüfsignals erzeugt wird, über einen Messeingang 336 der Prüfanschlüsse 330 zu empfangen und ein Datensignal, welches das erste Messsignal kennzeichnet, unter galvanischer Trennung über die Anschlussanordnung 320 und die Anschlussanordnung 121 durch eines der Hybridkabel 20 an das portable Hauptgerät 100 digital zu übertragen. Dabei können das portable Hauptgerät 100 und das portable Zusatzgerät 300 auch räumlich voneinander getrennt aufgestellt werden, wodurch sich insbesondere in Kombination mit der galvanischen Trennung die Betriebssicherheit erhöhen lässt.

In einer alternativen Ausführungsform sind die Anschlussanordnungen 120, 121, 220, 320 durch einen Booster-Stecker bzw. eine Booster-Verbindung realisiert.

In alternativen Varianten kann das Zusatzgerät 300 auch einen digitalen Messeingang zum Empfangen eines entsprechend digitalen Messsignals aufweisen und/oder ein analoges Datensignal übertragen. Die digitale Übertragung des Datensignals kann insbesondere den Vorteil haben, dass sich eine galvanische Trennung leichter und/oder mit einer besseren Genauigkeit implementieren lässt und/oder dass sich Störungen im Messsignal und somit bei der Messung bzw. Prüfung vermeiden oder zumindest reduzieren lassen. Dabei kann die Sensoreinrichtung 366 eingerichtet sein, das am Messeingang 336 empfangene erste analoge Messsignal zu erfassen sowie zu digitalisieren und als das Datensignal bereitzustellen.

Schließlich ist die Steuerungseinrichtung 180 eingerichtet, für die erste Prüfung mittels der Messeinrichtung 160 eine erste Messgröße zu messen, welche auf dem ersten Messsignal basiert. Für eine Verlustfaktormessung bezüglich der Hochspannungseinrichtung 30 ist das analoge Messsignal ein bei angelegter Wechselspannung durch ein Isolationsmittel der Hochspannungsvorrichtung 30 fließender Wechselstrom, wobei als Messgrößen zumindest die Amplitude oder der Effektivwert des Wechselstroms sowie die Phasenlage des Wechselstroms zur angelegten Wechselspannung gemessen werden oder der zeitlich bestimmte Signalverlauf des Wechselstroms gemessen wird.

In einigen Varianten ist die Steuerungseinrichtung 180 zudem eingerichtet, zur Datenkommunikation über die zweite Gruppe 128 der Anschlüsse der Anschlussanordnung 120 ein ausfallabgesichertes Kommunikationsprotokoll auszuführen und, falls bei der Datenkommunikation ein bestimmter Fehler auftritt, einen Fehlermodus des portablen Hauptgeräts zu aktivieren, in welchem kein Leistungssignal über die erste Gruppe 122 der Anschlüsse ausgegeben wird oder in welchem die Steuerungseinrichtung 180 veranlasst, dass das portable Zusatzgerät 300 einen Fehlermodus des portablen Zusatzgeräts aktiviert. So kann etwa, wenn die Datenkommunikation unterbrochen wird, dies aufgrund des ausfallabgesicherten Kommunikationsprotokolls festgestellt werden und als Folge kein Leistungssignal mehr ausgegeben werden, wodurch sich die Betriebssicherheit steigern lässt. Auch kann etwa, wenn die Datenkommunikation mehr als eine vorbestimmte Zeitspanne verzögert ist, der Fehlermodus des Zusatzgeräts 300 aktiviert werden, wobei dieses eingerichtet sein kann, daraufhin kein Prüfsignal mehr auszugeben oder die Hochspannungseinrichtung 30 von den Prüfanschlüssen 330 zu trennen oder das Messsignal nicht weiter zu erfassen oder als Datensignal nicht mehr an das portable Hauptgerät 100 zu senden, womit sich die Betriebssicherheit erhöhen und/oder die Verlässlichkeit oder Genauigkeit bei Prüfungen bzw. Messungen steigern lässt.

Ebenso können bei Übertragung der zuvor erwähnten Sicherheitssignale über das Hybridkabel 20 bei Vorliegen entsprechender Bedingungen Sicherheitsfunktionen des Prüfsystems ausgelöst und beispielsweise Komponenten des Hauptgeräts 100 oder der Zusatzgeräte 200, 300 deaktiviert werden, um die Betriebssicherheit zu erhöhen.

Bei einige Varianten können das Hauptgerät 100 und das Zusatzgerät 300 (oder auch des Zusatzgerät 200) eingerichtet sein, sich untereinander zu synchronisieren. Dabei ist das Hauptgerät 100 eingerichtet, zur Synchronisierung ein Synchronisierungssignal über die zweite Gruppe 128 der Anschlüsse der Anschlussanordnung 120 auszugeben. Zudem sind der Zeitgeber 106 des Hauptgeräts 100 und der Zeitgeber 306 des portablen Zusatzgeräts 300 eingerichtet, ihre jeweiligen Zeitsignale derart basierend auf dem Synchronisierungssignal anzugleichen, dass eine Zeitdifferenz zwischen diesen kleiner als eine vorbestimmte Zeitspanne ist. Auch sind das portable Hauptgerät 100 und das portable Zusatzgerät 300 in einigen Varianten eingerichtet, sich mittels des IEC 1588 Protokolls zu synchronisieren, wobei in einigen Varianten davon eine dafür erforderliche Datenkommunikation über die zweite Gruppe 128 der Anschlüsse der Anschlussanordnung 120 sowie über die zweite Gruppe 328 der Anschlüsse der Anschlussanordnung 320 erfolgt.

**In** einigen Varianten ist das portable Hauptgerät 100 - vorteilhaft in Kombination mit einer zeitlichen Synchronisierung und/oder einem ausfallabgesicherten Kommunikationsprotokoll - eingerichtet, das Leistungssignal in Echtzeit zu erzeugen oder das portable Zusatzgerät 300 über die Anschlussanordnung 121 in Echtzeit zu steuern, sodass das portable Zusatzgerät 300 ein Prüfsignal erzeugt, und weiterhin eingerichtet, eine Messgröße basierend auf einem Messsignal, welches infolge des Prüfsignals erzeugt wird, in Echtzeit zu messen.

Bei Varianten, bei welchen das portable Zusatzgerät 300 eingerichtet ist, ein Messsignal zu erfassen und insbesondere ein analoges Messsignal zu digitalisieren, ist das portable Zusatzgerät 300 in einigen vorteilhaften Varianten davon eingerichtet, das Messsignal bzw. das digitalisierte Messsignal mit einem Zeitcode, der einen Erfassungszeitpunkt des Signals kennzeichnet und der auf dem Zeitsignal des internen Zeitgebers 306 basiert, zu versehen und dieses mit Zeitcode versehene Signal als ein Datensignal über die Anschlussanordnung 320 und insbesondere die Anschlüsse der zweiten Gruppe 328 für das portable Hauptgerät 100 bereitzustellen.

In einigen vorteilhaften Varianten für eine mehrphasige Hochspannungseinrichtung weist das portable Hauptgerät 100 und/oder das Zusatzgerät 300 oder das weitere Zusatzgerät 200 weitere Kanäle mit weiteren Prüfanschlüssen - wie etwa Ausgangsanschlüssen oder Messanschlüssen - für die mehreren Phasen der Hochspannungseinrichtung auf, sodass sich eine mehrphasige Prüfung - etwa des Isolationswiderstands, des Verlustfaktors oder des Übersetzungsverhältnisses - ohne Änderung der Verkabelung und damit effizienter und/oder sicherer durchführen lässt.

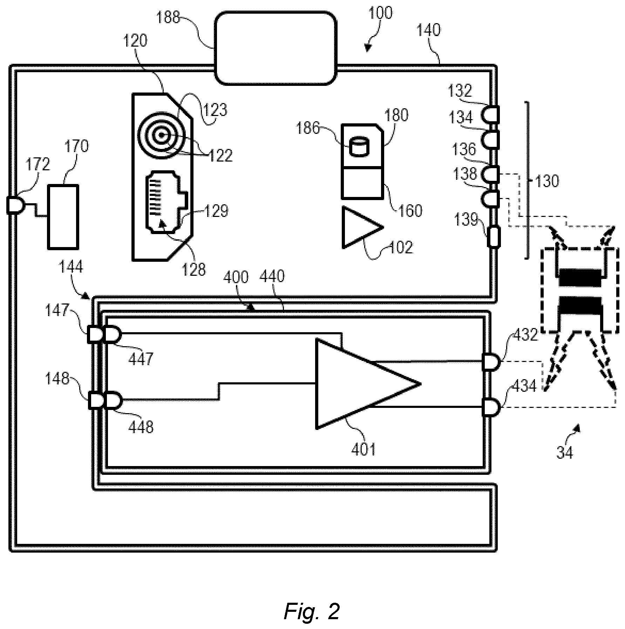

Fig. 2 zeigt schematisch ein portables Hauptgerät 100 nach einer Ausführungsform der vorliegenden Erfindung zur Prüfung einer Elektroenergieeinrichtung oder Hochspannungseinrichtung. Dabei kann das portable Hauptgerät 100 gemäß dem portablen Hauptgerät von Fig. 1 oder gemäß der Beschreibung bezüglich Fig. 1 ausgebildet sein und insbesondere auch über mechanische Verbindungselemente verfügen, welche in Fig. 2 der Übersichtlichkeit halber nicht dargestellt sind, da Fig. 2 im Wesentlichen den internen Aufbau und die Funktionsweise des Hauptgeräts 100 betrifft.

Das portable Hauptgerät 100 weist ein Gehäuse 140 sowie eine am Gehäuse 140 angeordnete elektrische Anschlussanordnung 120 zum Anschließen eines portablen Zusatzgeräts auf, wobei die Anschlussanordnung 120 vorzugsweise nur Anschlüsse 122, 128 aufweist, die alle weniger als einen vorbestimmten Abstand derart voneinander entfernt sind, dass diese mit genau einem Ende eines Kabels verbunden werden können. Dabei weist die Anschlussanordnung 120 eine erste Buchse 123 auf, die eine erste Gruppe 122 der Anschlüsse der Anschlussanordnung 120 zur Ausgabe eines Leistungssignals enthält, und eine zweite Buchse 129, die eine zweite Gruppe 128 der Anschlüsse der Anschlussanordnung 128 zur Datenkommunikation enthält. In alternativen Varianten kann das portable Hauptgerät 100 bzw. die Anschlussanordnung 120 statt der ersten oder zweiten Buchse 123, 129 auch andere elektrische Verbindungselemente etwa jeweils einen Stecker oder einen gemeinsamen Stecker oder eine gemeinsame Buchse aufweisen.

In Fig. 2 ist darüber hinaus auch die zu prüfende Hochspannungseinrichtung 34 dargestellt.

Das portable Hauptgerät 100 weist weiterhin mehrere Prüfanschlüsse 130 zum Anschließen der Hochspannungseinrichtung 34 auf, welche am Gehäuse 140 angeordnet sind. Zudem weist das Hauptgerät 100 eine Leistungsverstärkereinrichtung 102 zum Erzeugen des Leistungssignals und eines Prüfsignals, eine Messeinrichtung 160 für ein Messen von Messgrößen und eine Steuerungseinrichtung 180 zum Steuern der Leistungsverstärkereinrichtung 102 und der Messeinrichtung 160 sowie eine Speichereinrichtung 186 zum Speichern der Messgrößen auf, welche jeweils innerhalb des Gehäuses 140 angeordnet sind. Ein Vorteil von Varianten mit integrierter Messeinrichtung 160, Steuerungseinrichtung 180 und Leistungsverstärkereinrichtung 102 kann insbesondere darin liegen, dass ein solches Hauptgerät 100 bereits die volle Messfunktionalität bereitstellen kann und mittels der Leistungsverstärkereinrichtung 102 auch bereits einen Prüfstrom für einige Prüfungen einer Hochspannungseinrichtung oder einer Elektroenergieeinrichtung oder ein entsprechendes Prüfsignal oder eine entsprechende Prüfspannung bereitstellen kann, womit sich insbesondere auch ohne einem portablen Zusatzgerät bereits einige Prüfungen durchführen lassen. Vorteilhaft lassen sich mittels der Speichereinrichtung 186 gemessene Messgrößen - etwa für eine spätere Auswertung oder Protokollierung -, insbesondere automatisch, abspeichern, womit sich insbesondere die Handhabung des Hauptgeräts 100 und/oder eines Prüfsystems mit einem solchen Hauptgerät verbessern lässt. Alternative Varianten davon können auch keine derartige Speichereinrichtung aufweisen.

In einigen Varianten sind die Prüfanschlüsse 130 von den Anschlüssen 122, 128 der Anschlussanordnung 120, d.h. insbesondere von der ersten Buchse 123 und von der zweiten Buchse 129, separat, wodurch sich insbesondere die Handhabung vereinfachen und/oder die Betriebssicherheit steigern lässt.

Für ein Durchführen von Prüfungen ohne Zusatzgeräte oder Erweiterungsmodule, insbesondere für eine zweite Prüfung der Hochspannungseinrichtung 34, weisen die Prüfanschlüsse einen ersten Ausgangsanschluss 132, einen zweiten Ausgangsanschluss 134, einen ersten analogen Messeingang 136 und einen zweiten analogen Messeingang 138 auf. In einigen Varianten kann das portable Hauptgerät 100 außerdem eine Digitalschnittstelle 139 aufweisen, wobei diese als ein digitaler Messeingang 139 in einigen Varianten davon als Teil der Prüfanschlüsse 130 ausgebildet sein kann. Alternative Varianten können auch nur einen Ausgangsanschluss und als Messeingang einen analogen Messeingang oder einen digitalen Messeingang aufweisen.

Für die zweite Prüfung ist die Steuerungseinrichtung 180 eingerichtet, mittels der Leistungsverstärkereinrichtung 102 ein zweites Prüfsignal mit einem geeigneten Strom oder einer geeigneten Spannung zu erzeugen und an die an die Ausgangsanschlüsse 132, 134 anzuschließende Hochspannungseinrichtung 34 anzulegen sowie anhand eines zweiten elektrischen analogen Messsignals, welches an bzw. zwischen den analogen Messeingängen 136, 138 bei auch dort angeschlossener Hochspannungseinrichtung 34 in Folge des zweiten Prüfsignals anliegt, mittels der Messeinrichtung eine zweite Messgröße zu messen

In einer alternativen oder zusätzlichen Variante mit einem digitalen Messeingang 139 sind die Steuerungseinrichtung 180 und die Messeinrichtung 160 eingerichtet, für die zweite Prüfung die zweite Messgröße anhand eines zweiten Messsignals, welches infolge des zweiten Prüfsignals erzeugt wird und an den digitalen Messeingang übertragen wird, zu messen. Bei einem zu prüfenden Messwandler kann für eine Übersetzungszahlverhältnismessung als die zweite Prüfung etwa eine Primärseite dieses Messwandlers an die Ausgangsanschlüsse 132, 134 angeschlossen werden, ein Prüfstrom als das zweite Prüfsignal mittels der Leistungsverstärkereinrichtung 102 erzeugt und über die Ausgangsanschlüsse 132, 134 in den Messwandler eingespeist werden und schließlich ein vom Messwandler erfasster Stromwert, welcher infolge des eingespeisten Prüfstroms erzeugt und über eine digitale Schnittstelle des Messwandlers ausgegeben wird, über den digitalen Messeingang 139 empfangen und mittels der Messeinrichtung 160 gemessen werden, wobei die Messeinrichtung 160 weiter das Übersetzungszahlverhältnis basierend auf dem eingespeisten Strom und dem gemessenen Stromwert misst bzw. bestimmt.

Für die zweite Prüfung oder für eine weitere Prüfung sind in einigen Varianten die Steuerungseinrichtung 180 und die Digitalschnittstelle 139 eingerichtet, Steuerungssignale an eine weitere Komponente eines Prüfsystems oder eine Komponente der zu prüfenden Elektroenergieeinrichtung zu senden und infolgedessen erzeugte (weitere) digitale Messsignale von dieser Komponente oder von einer noch weiteren Komponente zu empfangen, wobei die Messeinrichtung 160 oder die Steuerungseinrichtung 180 eingerichtet ist, diese weiteren digitalen Messsignale auszuwerten. In einigen Varianten davon ist das portable Hauptgerät 100 eingerichtet, mittels des IEC 61850 Protokolls zu kommunizieren.

Das portable Hauptgerät 100 weist in einigen Varianten eine Energieversorgungseinrichtung 170, insbesondere innerhalb des Gehäuses 140, sowie einen am Gehäuse 140 angeordneten Netzanschluss 172 auf. Dabei ist das portable Hauptgerät 100 eingerichtet, bei am Netzanschluss 172 angeschlossenen Stromnetz das portable Hauptgerät selbst sowie über die Anschlussanordnung 120 angeschlossene Zusatzgeräte oder über weitere Anschlüsse angeschlossene Zusatzgeräte oder Erweiterungsmodule mit elektrischer Energie aus dem Stromnetz zu versorgen. Dazu ist in einigen vorteilhaften Varianten die zweite Gruppe 128 der Anschlüsse der Anschlussanordnung 120 des portablen Hauptgeräts 100 zudem zur Energieversorgung des anzuschließenden portablen Zusatzgeräts eingerichtet. In alternativen Varianten kann das portable Hauptgerät und/oder können Zusatzgeräte oder Erweiterungsmodule auch über eine externe Energieversorgungseinrichtung oder über eine jeweilige Energieversorgungseinrichtung des jeweiligen Zusatzgeräts oder Erweiterungsmoduls mit elektrische Energie versorgt werden.

In einigen Varianten weist die Anschlussanordnung 120 für die zweite Gruppe 128 an Anschlüssen und insbesondere als zweites Verbindungselement 129 eine EtherCAT-Schnittstelle auf. Dabei ist die Steuerungseinrichtung 180 eingerichtet, mit einem an die Anschlussanordnung 120 anzuschließendem portablen Zusatzgerät mittels einem EtherCAT-Protokoll über die EtherCAT-Schnittstelle 129 zu kommunizieren. In vorteilhaften Varianten davon ist die EtherCAT-Schnittstelle weiterhin eingerichtet, das portable Zusatzgerät mittels Power-over-Ethernet mit elektrischer Energie zu versorgen.

Das portable Hauptgerät 100 weist in einigen Varianten mit einem Zeitgeber und/oder mit einem ausfallabgesicherten Kommunikationsprotokoll eine Schnittstelle für ein Protokoll gemäß IEC 1588 auf, wobei die Steuerungseinrichtung 180 eingerichtet ist, als Taktgeber zu Synchronisationszwecken für Kommunikationsanwendungen mit herkömmlichen und/oder mit digitalen Sub-Stations zu dienen.

Durch Varianten, bei welchen die Leistungsverstärkereinrichtung 102 eingerichtet ist, als das Leistungssignal oder als ein Prüfsignal frei einstellbare Signalformen zu erzeugen, lassen sich vorteilhaft ein Gleichstrom und/oder eine oder mehrere Wechselströme bzw. eine Gleichspannung und/oder eine oder mehrere Wechselspannungen überlagern, womit insbesondere ein Messablauf bei zumindest im Wesentlichen gleicher Genauigkeit zeitlich verkürzt oder nicht-lineare Effekte - etwa bei einer "Power-Quality-Messung" - gemessen werden können. Auch wird es vorteilhaft ermöglicht, das portable Hauptgerät für verschiedene durchzuführende Prüfungen anzupassen, indem eine für die jeweilige Prüfung geeignete Signalform vorgegeben bzw. ausgewählt wird, womit eine Flexibilität gegenüber Lösungen mit fest vorgegebenen Signalformen - etwa nur Gleichspannung oder nur Wechselspannung mit bestimmten Amplituden oder Frequenzen - erhöht und/oder die Handhabung verbessert werden kann.

In einigen vorteilhaften Varianten mit Speichereinrichtung 186 sind die Messeinrichtung 160 und die Steuerungseinrichtung 180 eingerichtet, Messgrößen oder davon abgeleitete Größen für die Prüfung der Hochspannungseinrichtung bzw. der Elektroenergieeinrichtung basierend auf einem elektrisch-physikalischen Modell der Hochspannungseinrichtung/Elektroenergieeinrichtung zu bestimmen, wobei die Messgrößen oder weitere Größen als Parameter des elektrisch-physikalischen Modells numerisch optimiert werden. Hierbei können auch mehrere Durchgänge einer solchen Prüfung oder Ergebnisse von mehreren unterschiedlichen Prüfungen bezüglich der Hochspannungseinrichtung/Elektroenergieeinrichtung kombiniert werden, wodurch sich insbesondere die Genauigkeit der Prüfung/Messung, d. h. insbesondere der auf diese Weise bestimmten Messgrößen oder weiteren Größen steigern lässt. Alternativ oder zusätzlich können die Messgrößen oder weitere Größen auch mit einem herkömmlichen Ansatz bestimmt werden, bei welchem insbesondere die zu bestimmenden Werte ohne numerischer Optimierung, insbesondere unmittelbar etwa mittels einer eindeutig lösbaren Formel, aus erfassten Messwerten bestimmt werden.

Wie in Fig. 2 dargestellt, weist das Gehäuse 140 des Hauptgeräts 100 weiterhin einen Modulplatz 144 zur Aufnahme und zur Verbindung mit einem Erweiterungsmodul auf. Dabei ist das portable Hauptgerät 100 eingerichtet, ein im Modulplatz 144 aufgenommenes Erweiterungsmodul mit Energie zu versorgen und mittels der Steuerungseinrichtung 180 zu steuern.

Fig. 2 zeigt zudem ein Hochstrommodul zur Prüfung der Elektroenergieeinrichtung 34 mit einem Prüfstrom, wobei das portable Hauptgerät 100 dieses Hochstrommodul 400 als das Erweiterungsmodul aufweist und ein Gehäuse 440 des Hochstrommoduls 400 für den Modulplatz 144 eingerichtet ist und dazu in einigen Varianten für einen Formschluss mit dem Modulplatz 144 geformt ist. In alternativen Varianten kann das portable Hauptgerät 100 auch andere Erweiterungsmodule oder kein Erweiterungsmodul oder zusätzliche Modulplätze aufweisen. Zur Versorgung mit elektrischer Energie weist der Modulplatz 144 ein Steckverbindungselement 147 auf und weist das Erweiterungsmodul bzw. das Hochstrommodul 400 ein damit korrespondierendes, am Gehäuse 440 angeordnetes Steckverbindungselement 447 auf. Zur Steuerung mittels der Steuerungseinrichtung weist der Modulplatz 144 ein weiteres Steckverbindungselement 148 auf und das Erweiterungsmodul 400 weist ein damit korrespondierendes, am Gehäuse 440 angeordnetes weiteres Steckverbindungselement 448 auf. Außerdem weist das Hochstrommodul 400 eine Hochstromquelle 401 innerhalb des Gehäuses 440 sowie am Gehäuse 440 angeordnet einen ersten und einen zweiten Hochstromanschluss 432, 434 auf. Das Hochstrommodul 400 kann dazu eingerichtet sein, gesteuert durch die Steuerungseinrichtung 180 für eine dritte Prüfung ein Hochstromsignal mittels der Hochstromquelle 401 zu erzeugen und an den Hochstromanschlüssen 432,434 als Prüfsignal bereitzustellen.

Das portable Hauptgerät 100 weist weiterhin in einigen Varianten eine Benutzerschnittstelle 188 auf, die am Gehäuse 140 angeordnet ist und die eingerichtet ist, Eingaben von einem Benutzer zu erfassen, basierend darauf die Steuerungseinrichtung 180 zu veranlassen, eine Prüfung der Hochspannungseinrichtung bzw. der Elektroenergieeinrichtung 34 durchzuführen, und eine oder mehrere durch das Durchführen gemessene Messgrößen für den Benutzer auszugeben. Auch kann eine Sequenz von Prüfungen ausgeführt werden, wobei vorteilhaft die gemessenen Messgrößen sowie weitere Parameter, Eigenschaften oder Funktionen der Hochspannungseinrichtung bzw. der Elektroenergieeinrichtung modellbasiert, d. h. insbesondere mit einem elektrisch-physikalischen Modell bestimmt werden, in welches erfasste Messwerte von mehreren Prüfungen einfließen.

Dabei ist die Steuerungseinrichtung 180 eingerichtet, die Leistungsverstärkereinrichtung 102 und für Zusatzprüfungen etwaige portable Zusatzgeräte oder Erweiterungsmodule jeweils derart zu steuern, dass diese ein jeweils geeignetes Prüfsignal oder Leistungssignal erzeugen. Zudem ist die Steuerungseinrichtung 180 dabei eingerichtet, eine oder mehrere entsprechende Messgrößen mittels der Messeinrichtung 160 und etwaigen Zusatzgeräten oder Erweiterungsmodulen zu messen sowie die Messgrößen mittels der Speichereinrichtung 186 zu speichern.

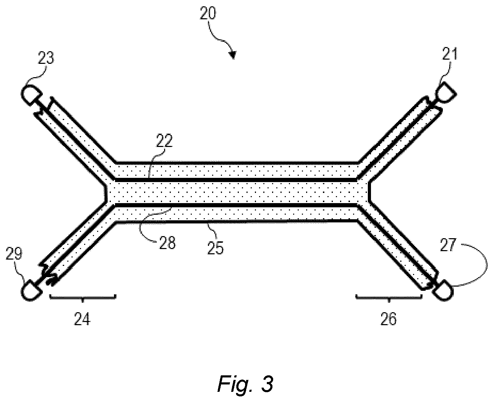

Fig. 3 zeigt schematisch ein Hybridkabel 20 nach einer Ausführungsform der vorliegenden Erfindung zur Verbindung eines portablen Hauptgeräts mit einem portablen Zusatzgerät.

In einem Ausführungsbeispiel weist das Hybridkabel 20 mindestens eine Leitung 22 zur Übertragung eines Leistungssignals und mindestens eine Leitung 28 zur Datenkommunikation und/oder zur Übertragung eines Sicherheitssignals auf. Zudem weist das Hybridkabel 20 ein an einem Ende 24 für das portable Hauptgerät angeordnetes erstes elektrisches Verbindungselement 23 zur lösbaren Verbindung mit einem ersten elektrischen Verbindungselement - etwa dem Verbindungselement 123 aus Fig. 2 - eine Anschlussanordnung des portablen Hauptgeräts auf. Weiterhin weist das Hybridkabel ein an einem anderen Ende 26 für das portable Zusatzgerät angeordnetes, erstes elektrisches Verbindungselement 21 zur lösbaren Verbindung mit einem ersten elektrischen Verbindungselement einer Anschlussanordnung - etwa der Anschlussanordnung 220 oder 320 aus Fig. 1 - des portablen Zusatzgeräts auf.

In einigen Varianten weist das Hybridkabel 20 wenigstens eine Erdungsleitung auf. In einigen Varianten davon sind die ersten elektrischen Verbindungselemente 21, 23 eingerichtet, auch die Erdungsleitung mit entsprechenden Anschlüssen von der Anschlussanordnung des portablen Hauptgeräts sowie von der Anschlussanordnung des portablen Zusatzgeräts lösbar elektrisch zu verbinden. In alternativen Varianten davon weist das Hybridkabel 20 am Ende 24 und/oder am Ende 26 jeweils ein weiteres elektrisches Verbindungselement für die Erdungsleitung auf.

Wie dargestellt, weist das Hybridkabel 20 außerdem ein am Ende 24 für das portable Hauptgerät angeordnetes, zweites elektrisches Verbindungselement 29 zur Verbindung mit einem zweiten elektrischen Verbindungselement der Anschlussanordnung des portablen Hauptgeräts - etwa dem elektrischen Verbindungselement 129 aus Fig. 2 - auf. Weiterhin weist das Hybridkabel 20 ein am Ende 26 für das portable Zusatzgerät angeordnetes, zweites elektrisches Verbindungselement 27 zur Verbindung mit einem zweiten elektrischen Verbindungselement der Anschlussanordnung des portablen Zusatzgeräts auf. Dabei sind die zweiten Verbindungselemente 24, 27 eingerichtet, die Leitungen 28 zur Datenkommunikation bzw. Sicherheitssignalübertragung am Ende 24 für das portable Hauptgerät mit entsprechenden Anschlüssen - etwa der zweiten Gruppe 128 an Anschlüssen aus Fig. 1 - der Anschlussanordnung des portablen Hauptgeräts lösbar elektrisch zu verbinden und am Ende 26 für das portable Zusatzgerät mit entsprechenden Anschlüssen - etwa den Anschlüssen 228 oder 328 aus Fig. 1 - der Anschlussanordnung des portablen Zusatzgeräts lösbar elektrisch zu verbinden.

In einigen Varianten sind die elektrischen Verbindungselemente 21, 23, 27, 29 jeweils als Stecker ausgebildet. Alternativ kann, insbesondere zur Erhöhung der Sicherheit, das erste elektrische Verbindungselement 21 am Ende 26 auch als Buchse ausgebildet sein, sodass dieses keine offen liegenden Kontakte aufweist und somit ein etwaig anliegendes Leistungssignal vor einer Berührung schützt. Auch kann das zweite elektrische Verbindungselement 27 am Ende 26 als Buchse ausgebildet sein, sodass in Kombination mit einem als Buchse ausgebildeten elektrischen Verbindungselement 21 mehrere derartige Hybridkabel miteinander verbunden werden können, um ein längeres Hybridkabel zu erhalten.

In alternativen Varianten kann das Hybridkabel bei jedem Ende 24, 26 jeweils nur das jeweilige erste elektrische Verbindungselement aufweisen, wobei diese eingerichtet sind, zudem die Leitungen 28 zur Datenkommunikation und/oder Sicherheitssignalübertragung am Ende 24 mit entsprechenden Anschlüssen der Anschlussanordnung des portablen Hauptgeräts lösbar zu verbinden und am Ende 26 für das portable Zusatzgerät mit entsprechenden Anschlüssen der Anschlussanordnung des portablen Zusatzgeräts lösbar elektrisch zu verbinden. In dieser Variante kann das Hybridkabel dann sowohl für das portable Hauptgerät am Ende 24 als auch für das portable Zusatzgerät am Ende 26 einen Hybrid-Stecker aufweisen, in den jeweils die Funktionen der Verbindungselemente 23 und 29 bzw. 21 und 27 integriert sind, d.h. alle Leitungen und Anschlüsse sind dann in dem einen Kabel 20 und an beiden Enden 24, 26 in jeweils lediglich einem Stecker oder Verbindungselement ausgebildet.

Das Hybridkabel 20 weist einen Kabelmantel 25 auf, welcher zumindest in einem Mittenabschnitt des Hybridkabels alle Leitungen 22, 28 umhüllt und bei einem Endabschnitt am Ende 24 jeweils einzeln die Leitungen 22 und die Leitungen 28 umhüllt sowie entsprechend bei einem Endabschnitt am Ende 26 zum einen die Leitungen 22 und zum anderen die Leitungen 28 umhüllt.

## Patentansprüche

1. Prüfsystem (10) zur Prüfung einer elektrischen Einrichtung (30, 34), umfassend:
ein portables Hauptgerät (100) mit einem ersten Gehäuse (140) und einer an dem ersten Gehäuse angeordneten ersten mechanischen Verbindungsanordnung (145) und einer an dem ersten Gehäuse angeordneten ersten elektrischen Anschlussanordnung (120, 121), und
ein von dem portablen Hauptgerät (100) separates portables Zusatzgerät (200, 300) mit einem zweiten Gehäuse (240, 340) und einer an dem zweiten Gehäuse angeordneten zweiten mechanischen Verbindunganordnung (245) und einer an dem zweiten Gehäuse angeordneten zweiten elektrischen Anschlussanordnung (220, 320),
wobei das portable Hauptgerät (100) mit dem portablen Zusatzgerät (200, 300) durch Kopplung der ersten mechanischen Verbindungsanordnung (145) mit der zweiten mechanischen Verbindungsanordnung (245) lösbar mechanisch zu einer baulichen Einheit verbindbar ist, und
wobei das portable Hauptgerät (100) mit dem portablen Zusatzgerät (200, 300) über die erste elektrische Anschlussanordnung (120, 121) und die zweite elektrische Anschlussanordnung (220, 320) elektrisch verbindbar ist,
**dadurch gekennzeichnet,**
**dass** das portable Hauptgerät (100) eine Leistungsverstärkereinrichtung (102) zum Erzeugen eines Leistungssignals (22), welches an das portable Zusatzgerät (200, 300) über die erste elektrische Anschlussanordnung (120, 121) und die zweite elektrische Anschlussanordnung (220, 320) zu übertragen ist, aufweist,
**dass** das portable Zusatzgerät (200, 300) eine Prüfsignalvorrichtung (302) zur Erzeugung eines an die elektrische Einrichtung (30, 34) auszugebenden Prüfsignals auf Grundlage des Leistungssignals (22) des portablen Hauptgeräts (100) aufweist, und
**dass** das portable Hauptgerät (100) eine Messeinrichtung (160) zum Messen einer Messgröße der elektrischen Einrichtung (30, 34) als Prüfantwort auf das Prüfsignal des portablen Zusatzgeräts (200, 300) aufweist.

2. Prüfsystem (10) nach Anspruch 1, wobei das portable Hauptgerät (100) und das portable Zusatzgerät (200, 300) an Kontaktflächen (141, 243) des portablen Hauptgeräts (100) und des portablen Zusatzgeräts (200, 300) zu der baulichen Einheit lösbar verbindbar sind, wobei Abmessungen der Kontaktfläche (141) des portablen Hauptgeräts (100) im Wesentlichen Abmessungen der Kontaktfläche (243) des portablen Zusatzgeräts (200, 300) entsprechen,

3. Prüfsystem (10) nach Anspruch 1 oder Anspruch 2, wobei die erste mechanische Verbindungsanordnung (145) und die zweite mechanische Verbindungsanordnung (245) derart ausgestaltet sind, dass das portable Hauptgerät (100) mit dem portablen Zusatzgerät (200, 300) kraftschlüssig, formschlüssig und/oder reibschlüssig zu der baulichen Einheit verbindbar ist.

4. Prüfsystem (10) nach einem der vorhergehenden Ansprüche, wobei das erste Gehäuse (140) des portablen Hauptgeräts (100) und das zweite Gehäuse (240, 340) des portablen Zusatzgeräts (200, 300) im Wesentlichen dieselben Abmessungen aufweisen.

5. Prüfsystem (10) nach einem der vorhergehenden Ansprüche, wobei das portable Zusatzgerät (200, 300) einen Transformator (302) als die Prüfsignalvorrichtung aufweist und derart eingerichtet ist, dass das portable Zusatzgerät (300) das Leistungssignal des portablen Hauptgeräts (100) mittels des Transformators (302) in das Prüfsignal derart umwandelt, dass das Leistungssignal und das Prüfsignal galvanisch getrennt sind und das Prüfsignal eine Spannung von mindestens 1KV aufweist.

6. Prüfsystem (10) nach einem der vorhergehenden Ansprüche, wobei das portable Zusatzgerät (200, 300) derart ausgestaltet ist, dass das portable Zusatzgerät (200, 300) die Prüfantwort auf das Prüfsignal erfasst und an die Messeinrichtung (160) des portablen Hauptgeräts (100) überträgt.

7. Prüfsystem (10) nach einem der vorhergehenden Ansprüche, wobei das portable Hauptgerät (100) derart ausgestaltet ist, dass das portable Hauptgerät (100) die Prüfantwort auf das Prüfsignal des portablen Zusatzgeräts erfasst und an die Messeinrichtung (160) des portablen Hauptgeräts (100) weiterleitet.

8. Prüfsystem (10) nach einem der vorhergehenden Ansprüche, wobei das portable Hauptgerät (100) eine Steuerungseinrichtung (180) zum Steuern der Leistungsverstärkereinrichtung (102) und der Messeinrichtung (160) aufweist.

9. Prüfsystem (10) nach Anspruch 8, wobei die Steuerungseinrichtung (180) derart ausgestaltet ist, dass sie über eine elektrische Verbindung zwischen der ersten elektrischen Anschlussanordnung (120, 121) und der zweiten elektrischen Anschlussanordnung (220, 320) die Prüfsignalvorrichtung (302) des portablen Zusatzgeräts (200, 300) zur Erzeugung des an die elektrische Einrichtung (30, 34) auszugebenden Prüfsignals ansteuert.

10. Prüfsystem (10) nach Anspruch 8 oder Anspruch 9, wobei die Steuerungseinrichtung (180) derart ausgestaltet ist, dass sie über eine elektrische Verbindung zwischen der ersten elektrischen Anschlussanordnung (120, 121) und der zweiten elektrischen Anschlussanordnung (220, 320) die Prüfung der elektrischen Einrichtung (30, 34) durch das Prüfsignal des portablen Zusatzgeräts (200, 300) steuert.

11. Prüfsystem (10) nach einem der vorhergehenden Ansprüche, umfassend ein Hybridkabel (20), welches zur elektrischen Verbindung des portablen Hauptgeräts (100) mit dem portablen Zusatzgerät (200; 300) über die erste elektrische Anschlussanordnung (120) und die zweite elektrische Anschlussanordnung (220, 320) eingerichtet ist und zur gleichzeitigen Übertragung sowohl des Leistungssignals (22) als auch eines Datensignals (28) ausgestaltet.

12. Prüfsystem (10) nach Anspruch 11, wobei das Hybridkabel (20) zudem zur gleichzeitigen Übertragung eines Sicherheitssignals ausgestaltet ist.

13. Prüfsystem (10) nach Anspruch 12, wobei das Hybridkabel (20) umfasst:
ein an einem Ende (24) für das portable Hauptgerät (100) angeordnetes elektrisches Verbindungselement (23) zur lösbaren Verbindung mit der ersten elektrischen Anschlussanordnung (120) des portablen Hauptgeräts (100),
ein an einem anderen Ende (26) für das portable Zusatzgerät (200, 300) angeordnetes elektrisches Verbindungselement (21) zur lösbaren Verbindung mit der zweiten elektrischen Anschlussanordnung (220, 320) des portablen Zusatzgeräts (200, 300);
mindestens eine Leitung (22) zur Übertragung des Leistungssignals zwischen dem portablen Hauptgerät (100) und dem portablen Zusatzgerät (200, 300);
mindestens eine Leitung (28) zur Datenkommunikation zwischen dem portablen Hauptgerät (100) und dem portablen Zusatzgerät (200, 300); und
mindestens eine Leitung zur Übertragung des Sicherheitssignals zwischen dem portablen Hauptgerät (100) und dem portablen Zusatzgerät (200, 300)

14. Prüfsystem (10) nach einem der vorhergehenden Ansprüche, wobei das portable Hauptgerät (100) eine Energieversorgungseinrichtung (170) aufweist und zur Energieversorgung des portablen Zusatzgeräts (200, 300) mittels der Energieversorgungseinrichtung (170) ausgestaltet ist.

15. Prüfsystem (10) nach einem der vorhergehenden Ansprüche, wobei sowohl das portable Hauptgerät (100) als auch das portable Zusatzgerät (200, 300) als ein eigenständiges Messgerät ausgestaltet ist.

## Claims

1. A test system (10) for testing an electric device (30, 34), comprising:
a portable main device (100) with a first housing (140) and a first mechanical connection assembly (145) disposed on the first housing and a first electric connection assembly (120, 121) disposed on the first housing, and
a portable additional device (200, 300), separate from the portable main device (100), with a second housing (240, 340) and a second mechanical connection assembly (245) disposed on the second housing and a second electric connection assembly (220, 320) disposed on the second housing,
wherein the portable main device (100) can be mechanically connected to the portable additional device (200, 300) in a releasable manner by coupling the first mechanical connection assembly (145) to the second mechanical connection assembly (245) to form a structural unit, and
wherein the portable main device (100) can be electrically connected to the portable additional device (200, 300) via the first electric connection assembly (120, 121) and the second electric connection assembly (220, 320),
**characterized in**
**that** the portable main device (100) has a power-amplifying device (102) for generating a power signal (22) which is to be transmitted to the portable additional device (200, 300) via the first electric connection assembly (120, 121) and the second electric connection assembly (220, 320),
**that** the portable additional device (200, 300) has a test signal apparatus (302) for generating a test signal, which is to be output to the electric device (30, 34), on the basis of the power signal (22) of the portable main device (100), and
**that** the portable main device (100) has a measuring device (160) for measuring a measurement variable of the electric device (30, 34) as a test response to the test signal of the portable additional device (200, 300).

2. The test system (10) according to claim 1, wherein the portable main device (100) and the portable additional device (200, 300) can be connected in a releasable manner at contact surfaces (141, 243) of the portable main device (100) and of the portable additional device (200, 300) to form the structural unit, wherein dimensions of the contact surface (141) of the portable main device (100) substantially correspond to dimensions of the contact surface (243) of the portable additional device (200, 300).

3. The test system (10) according to claim 1 or claim 2, wherein the first mechanical connection assembly (145) and the second mechanical connection assembly (245) are formed such that the portable main device (100) can be connected to the portable additional device (200, 300) in a force-fitting, form-fitting and/or friction-fitting manner to form the structural unit.

4. The test system (10) according to any one of the preceding claims, wherein the first housing (140) of the portable main device (100) and the second housing (240, 340) of the portable additional device (200, 300) have substantially the same dimensions.

5. The test system (10) according to any one of the preceding claims, wherein the portable additional device (200, 300) has a transformer (302) as the test signal apparatus and is arranged such that the portable additional device (300) converts the power signal of the portable main device (100) into the test signal by means of the transformer (302) such that the power signal and the test signal are electrically isolated and the test signal has a voltage of at least 1KV.

6. The test system (10) according to any one of the preceding claims, wherein the portable additional device (200, 300) is formed such that the portable additional device (200, 300) records the test response to the test signal and transmits it to the measuring device (160) of the portable main device (100).

7. The test system (10) according to any one of the preceding claims, wherein the portable main device (100) is formed such that the portable main device (100) records the test response to the test signal of the portable additional device and forwards it to the measuring device (160) of the portable main device (100).

8. The test system (10) according to any one of the preceding claims, wherein the portable main device (100) has a controlling device (180) for controlling the power-amplifying device (102) and the measuring device (160).

9. The test system (10) according to claim 8, wherein the controlling device (180) is formed such that, via an electric connection between the first electric connection assembly (120, 121) and the second electric connection assembly (220, 320), it controls the test signal apparatus (302) of the portable additional device (200, 300) to generate the test signal to be output to the electric device (30, 34).

10. The test system (10) according to claim 8 or claim 9, wherein the controlling device (180) is formed such that, via an electric connection between the first electric connection assembly (120, 121) and the second electric connection assembly (220, 320), it controls the testing of the electric device (30, 40) through the test signal of the portable additional device (200, 300).

11. The test system (10) according to any one of the preceding claims, comprising a hybrid cable (20), which is arranged to electrically connect the portable main device (100) to the portable additional device (200; 300) via the first electric connection assembly (120) and the second electric connection assembly (220, 320) and formed to simultaneously transmit both the power signal (22) and a data signal (28).

12. The test system (10) according to claim 11, wherein the hybrid cable (20) is additionally formed to simultaneously transmit a safety signal.

13. The test system (10) according to claim 12, wherein the hybrid cable (20) comprises:
an electric connecting element (23) disposed at one end (24) for the portable main device (100) for releasable connection to the first electric connection assembly (120) of the portable main device (100),
an electric connecting element (21) arranged at a different end (26) for the portable additional device (200, 300) for releasable connection to the second electric connection assembly (220, 320) of the portable additional device (200, 300),
at least one wire (22) for transmitting the power signal between the portable main device (100) and the portable additional device (200, 300);
at least one wire (28) for data communication between the portable main device (100) and the portable additional device (200, 300); and
at least one wire for transmitting the safety signal between the portable main device (100) and the portable additional device (200, 300)

14. The test system (10) according to any one of the preceding claims, wherein the portable main device (100) has an energy supply device (170) and is formed to supply energy to the portable additional device (200, 300) by means of the energy supply device (170).

15. The test system (10) according to any one of the preceding claims, wherein both the portable main device (100) and the portable additional device (200, 300) are formed as an independent measuring device.

## Revendications

1. Système de test (10) permettant de tester un dispositif électrique (30, 34), comprenant :
un appareil principal portable (100) comportant un premier boîtier (140) et un premier agencement de liaison mécanique (145) disposé sur le premier boîtier et un premier agencement de connexion électrique (120, 121) disposé sur le premier boîtier, et
un appareil auxiliaire portable (200, 300) séparé de l'appareil principal portable (100) et comportant un second boîtier (240, 340) et un second agencement de liaison mécanique (245) disposé sur le second boîtier et un second agencement de connexion électrique (220, 320) disposé sur le second boîtier,
dans lequel l'appareil principal portable (100) peut être relié mécaniquement de manière amovible à l'appareil supplémentaire portable (200, 300) pour former une unité structurelle par accouplement du premier agencement de liaison mécanique (145) avec le second agencement de liaison mécanique (245), et
dans lequel l'appareil principal portable (100) peut être connecté électriquement à l'appareil auxiliaire portable (200, 300) par l'intermédiaire du premier agencement de connexion électrique (120, 121) et du second agencement de connexion électrique (220, 320), **caractérisé en ce**
**que** l'appareil principal portable (100) présente un dispositif amplificateur de puissance (102) permettant de générer un signal de puissance (22) qui doit être transmis à l'appareil auxiliaire portable (200, 300) par l'intermédiaire du premier agencement de connexion électrique (120, 121) et du second agencement de connexion électrique (220, 320),
**que** l'appareil auxiliaire portable (200, 300) présente un dispositif à signal de test (302) permettant de générer un signal de test à délivrer au dispositif électrique (30, 34) sur la base du signal de puissance (22) de l'appareil principal portable (100), et
**que** l'appareil principal portable (100) présente un dispositif de mesure (160) permettant de mesurer une grandeur de mesure du dispositif électrique (30, 34) en tant que réponse de test au signal de test de l'appareil supplémentaire portable (200, 300).

2. Système de test (10) selon la revendication 1, dans lequel l'appareil principal portable (100) et l'appareil supplémentaire portable (200, 300) peuvent être reliés de manière amovible au niveau de surfaces de contact (141, 243) de l'appareil principal portable (100) et de l'appareil supplémentaire portable (200, 300) pour former l'unité structurelle, dans lequel des dimensions de la surface de contact (141) de l'appareil principal portable (100) correspondent sensiblement à des dimensions de la surface de contact (243) de l'appareil supplémentaire portable (200, 300),

3. Système de test (10) selon la revendication 1 ou la revendication 2, dans lequel le premier agencement de liaison mécanique (145) et le second agencement de liaison mécanique (245) sont conçus de telle sorte que l'appareil principal portable (100) peut être relié à l'appareil supplémentaire portable (200, 300) par force, par complémentarité de forme et/ou par friction pour former l'unité structurelle.

4. Système de test (10) selon l'une des revendications précédentes, dans lequel le premier boîtier (140) de l'appareil principal portable (100) et le second boîtier (240, 340) de l'appareil supplémentaire portable (200, 300) présentent sensiblement les mêmes dimensions.

5. Système de test (10) selon l'une des revendications précédentes, dans lequel l'appareil supplémentaire portable (200, 300) présente un transformateur (302) en tant que dispositif à signal de test et est configuré de telle sorte que l'appareil supplémentaire portable (300) convertit le signal de puissance de l'appareil principal portable (100) en signal de test au moyen du transformateur (302), de telle sorte que le signal de puissance et le signal de test sont séparés galvaniquement et que le signal de test présente une tension d'au moins 1 KV.

6. Système de test (10) selon l'une des revendications précédentes, dans lequel l'appareil supplémentaire portable (200, 300) est configuré de telle sorte que l'appareil supplémentaire portable (200, 300) détecte la réponse de test au signal de test et la transmet au dispositif de mesure (160) de l'appareil principal portable (100).

7. Système de test (10) selon l'une des revendications précédentes, dans lequel l'appareil principal portable (100) est configuré de telle sorte que l'appareil principal portable (100) détecte la réponse de test au signal de test de l'appareil supplémentaire portable et la transmet au dispositif de mesure (160) de l'appareil principal portable (100).

8. Système de test (10) selon l'une des revendications précédentes, dans lequel l'appareil principal portable (100) présente un dispositif de commande (180) permettant de commander le dispositif amplificateur de puissance (102) et le dispositif de mesure (160).

9. Système de test (10) selon la revendication 8, dans lequel le dispositif de commande (180) est configuré de telle sorte qu'il commande, par l'intermédiaire d'une connexion électrique entre le premier agencement de connexion électrique (120, 121) et le second agencement de connexion électrique (220, 320), le dispositif à signal de test (302) de l'appareil supplémentaire portable (200, 300) afin de générer le signal de test à délivrer au dispositif électrique (30, 34).

10. Système de test (10) selon la revendication 8 ou la revendication 9, dans lequel le dispositif de commande (180) est configuré de telle sorte qu'il commande le test du dispositif électrique (30, 34) au moyen du signal de test de l'appareil supplémentaire portable (200, 300) par l'intermédiaire d'une connexion électrique entre le premier agencement de connexion électrique (120, 121) et le second agencement de connexion électrique (220, 320).

11. Système de test (10) selon l'une des revendications précédentes, comprenant un câble hybride (20) qui est configuré pour la connexion électrique de l'appareil principal portable (100) avec l'appareil supplémentaire portable (200 ; 300) par l'intermédiaire du premier agencement de connexion électrique (120) et du second agencement de connexion électrique (220, 320) et qui est configuré pour la transmission simultanée aussi bien du signal de puissance (22) que d'un signal de données (28).

12. Système de test (10) selon la revendication 11, dans lequel le câble hybride (20) est en outre configuré pour transmettre simultanément un signal de sécurité.

13. Système de test (10) selon la revendication 12, dans lequel le câble hybride (20) comprend :
un élément de connexion électrique (23) disposé à une extrémité (24) pour l'appareil principal portable (100) et destiné à une connexion amovible avec le premier agencement de connexion électrique (120) de l'appareil principal portable (100),
un élément de connexion électrique (21) disposé à une autre extrémité (26) pour l'appareil supplémentaire portable (200, 300) et destiné à une connexion amovible avec le second agencement de connexion électrique (220, 320) de l'appareil supplémentaire portable (200, 300) ;
au moins une ligne (22) permettant de transmettre le signal de puissance entre l'appareil principal portable (100) et l'appareil supplémentaire portable (200, 300) ;
au moins une ligne (28) pour la communication de données entre l'appareil principal portable (100) et l'appareil supplémentaire portable (200, 300) ; et
au moins une ligne pour la transmission du signal de sécurité entre l'appareil principal portable (100) et l'appareil supplémentaire portable (200, 300).

14. Système de test (10) selon l'une des revendications précédentes, dans lequel l'appareil principal portable (100) présente un dispositif d'alimentation en énergie (170) et est configuré pour alimenter en énergie l'appareil supplémentaire portable (200, 300) au moyen du dispositif d'alimentation en énergie (170).

15. Système de test (10) selon l'une des revendications précédentes, dans lequel aussi bien l'appareil principal portable (100) que l'appareil supplémentaire portable (200, 300) sont configurés comme un appareil de mesure autonome.
